# EUROPEAN PATENT SPECIFICATION

(11) **EP 3 968 031 B1**
(45) Date of publication and mention of the grant of the patent: **18.11.2026**
(21) Application number: 19927837.5
(22) Date of filing: 07.05.2019
(51) Int. Cl.: G01R 1/067, G01R 1/073, G01R 31/28

(54) **PROBE ASSEMBLY AND MICRO VACUUM PROBE STATION COMPRISING SAME**
SONDENANORDNUNG UND DIESE ENTHALTENDE MIKROVAKUUMSONDENSTATION
ENSEMBLE SONDE ET STATION DE SONDE À MICRO-VIDE COMPRENANT CETTE DERNIÈRE

(43) Date of publication of application: 16.03.2022
(73) Proprietor: Nextron Corp., Busan 46257 (KR)
(72) Inventor: MOON, Hakbeom, Yangsan-Si Gyeongsangnam-do 50608 (KR); JANG, Yunhyeong, Busan 47571 (KR); SEONG, Jisu, Yangsan-Si Gyeongsangnam-do 50540 (KR); KIM, Nakyeong, Busan 48402 (KR)
(74) Representative: DREISS Patentanwälte PartG mbB
(86) International application number: PCT/KR2019/005410
(87) International publication number: WO 2020/226194

(56) References cited:
- JP-A- 2000 150 595
- KR-A- 20090 046 086
- KR-A- 20090 125 509
- KR-A- 20100 057 118
- KR-B1- 100 951 717
- KR-B1- 101 055 343
- KR-B1- 101 724 954
- KR-B1- 101 724 954
- US-A1- 2017 052 216
- US-A1- 2019 004 087

## Description

### TECHNICAL FIELD

Example embodiments relate to a probe assembly and a micro vacuum probe station including the probe assembly.

### BACKGROUND ART

In a semiconductor manufacturing process, the material properties of a solid liquid sample formed on a wafer or base substrate may need to be examined. For example, electromagnetic, dielectric, optical, and chemical properties may need to be examined. Characteristics of a device may be affected by external factors, and thus an environment with the regulated vacuum state, light radiation, gas, temperature, and humidity may need to be provided in a process of detecting the characteristics of the device.

To detect the properties of a sample, a vacuum probe system that provides a chamber in which the sample is to be disposed may be provided. The vacuum probe system may detect characteristics of a device through a probe contacting the device. The vacuum probe system may include an adjuster that precisely moves the probe, and the adjuster may be disposed inside or outside the chamber.

In a case where the probe and the adjuster are disposed inside the chamber, the space of the chamber may increase, and a greater amount of time may thus be used to exhaust vacuum. In addition, as the size of the internal space of the chamber increases, controlling humidity and temperature may become harder in proportion to the increasing size, and external factors including unnecessary outgas may come into action. Thus, when the size of the chamber increases, the accuracy in measurement and analysis may be degraded. In contrast, in a case where the adjuster is disposed outside the chamber, a configuration of an instrument part for vacuum sealing inside and outside the chamber may become complicated and increase the cost, and the overall size may increase. In addition, installing the probe and the adjuster inside the chamber may have electrical, mechanical, and economic limitations. Thus, there is a desire for a small probe system that may effectively detect characteristics of a device while having both a probe and an adjuster disposed inside a chamber.

KR 101 055 343 B1 discloses an inspection apparatus used for simple lighting inspection and normal lighting inspection of a substrate to be inspected such as a liquid crystal panel.

KR 101 724 954 B1 discloses a micro vacuum probe station.

### DISCLOSURE OF THE INVENTION

### Technical Goals

An aspect provides a micro vacuum probe station having a probe assembly disposed inside a chamber to detect an electrical property of a sample.

Another aspect provides a probe assembly that accurately detects an electrical property of a sample irrespective of characteristics of an applied power supply and a micro vacuum probe station including the probe assembly.

Still another aspect provides a probe assembly that measures various properties of a sample in various changing environments with a high level of accuracy, and a micro vacuum probe station including the probe assembly.

### Technical Solutions

The invention is set out in the appended set of claims.

According to an example embodiment, there is provided a probe assembly including a base, a guide rail installed on the base, a guide member configured to slide along the guide rail, a probe connected to the guide member and configured to examine an electrical property of a sample as one side thereof is brought into contact with the sample, and a thin film connector connected to the other side of the probe such that electricity is applied to the probe.

The thin film connector includes a substrate layer including polyimide, a conductive layer including copper and stacked on one surface of the substrate layer, and a cover layer stacked on one surface of the substrate layer to cover the conductive layer.

The conductive layer includes a first conductive portion and a second conductive portion stacked on the substrate layer such that the first conductive portion and the second conductive portion are disposed at both ends of the substrate layer, and include a third conductive portion stacked on the substrate layer such that the third conductive portion is disposed between the first conductive portion and the second conductive portion. The first conductive portion, the second conductive portion, and the third conductive portion are separated from one another.

The probe assembly may further include a connecting portion configured to connect the guide member and the probe. The probe may be connected to the connecting portion such that the probe is rotatable on an axis perpendicular to the ground.

The connecting portion may include a connecting member connected to the guide member and having, in an upper portion thereof, an insertion groove into which a portion of the probe is to be inserted, a shaft provided in the connecting member to pass through the probe, and an elastic body connected to the shaft and configured to provide a restoring force such that the probe rotates in an opposite direction when the probe rotates through the shaft.

The probe may include a fixing portion connected to the guide member, an extension portion extending in a horizontal direction from one side of the fixing portion, and an examination portion extending downward from an end portion of the extension portion such that an end portion thereof comes into contact with the sample.

The probe may further include a bent portion configured to connect the fixing portion and the extension portion, and repeatedly bent such that the extension portion bends upward and downward with respect to the fixing portion.

The extension portion may include an adjustment groove formed by being bent upward. Into the adjustment groove, tweezers for manually adjusting a position of the probe may be inserted.

According to another example embodiment, there is provided a micro vacuum probe station including a housing having a chamber formed inside the housing and having an upper portion being opened, a housing cover connected to the upper portion of the housing to hermetically seal the chamber and including a transparent window, a vacuum port formed through the housing to form a vacuum in the chamber, an sample stage disposed in the chamber and on which a target sample is to be settled, and a probe assembly disposed in the chamber and configured to examine an electrical property of the sample as the probe assembly is brought into contact with the sample.

The probe assembly may include a base installed in the chamber, a guide rail provided in the base, a guide member configured to slide along the guide rail, a probe connected to the guide member and configured to examine the electrical property of the sample as one side thereof is brought into contact with the sample, and a thin film connector connected to the other side of the probe such that electricity is applied to the probe.

The thin film connector may include a substrate layer formed with an insulating material, a conductive layer stacked on one surface of the substrate layer and including three conductive portions disposed at both ends and a center of the substrate layer such that the conductive portions are separated from one another, and a cover layer stacked on one surface of the substrate layer to cover the conductive layer.

A direct current (DC) or alternating current (AC) voltage may be applied to the probe through the tine film connector.

The probe assembly may further include an elastic member disposed between a surface of a bottom of the chamber and the base.

The micro vacuum probe station may further include a cooling port formed through the housing such that a coolant flows into the chamber.

The sample stage may include a temperature adjuster configured to adjust a temperature of the sample.

### EFFECTS

According to an example embodiment described herein, a probe assembly and a micro vacuum probe station including the probe assembly may minimize the size of a chamber with the reduced size of the probe assembly, thereby reducing the amount of time used for a change in an environment such as vacuum exhaust and gas purging.

According to an example embodiment described herein, a probe assembly and a micro vacuum probe station including the probe assembly may be manufactured as being small in size and lightweight in volume, and may thus be readily compatible with an other instrument such as a microscope, a spectrometric analyzer, and the like.

According to an example embodiment described herein, a probe assembly and a micro vacuum probe station including the probe assembly may accurately detect an electrical property of a sample irrespective of characteristics of an applied power supply.

According to an example embodiment described herein, a probe assembly and a micro vacuum probe station including the probe assembly may improve accuracy in measurement by readily adjusting a movement of a probe with respect to a sample.

According to an example embodiment described herein, a probe assembly and a micro vacuum probe station including the probe assembly may fix a sample while detecting an electrical signal, and may thus respond to a vibration of a chamber and allow a direction and a movement of the chamber to be free.

### BRIEF DESCRIPTION OF DRAWINGS

FIG 1 is a perspective view of a micro vacuum probe station according to an example embodiment.
FIG 2 is a plan view of a micro vacuum probe station according to an example embodiment.
FIG 3 is a perspective view of a probe assembly according to an example embodiment.
FIG 4 is a side perspective view of a probe according to an example embodiment.
FIG 5 is a side view of a thin film connector according to the invention.
FIG 6 is a cross-sectional view of the thin film connector of FIG 5 cut by an A-A line.

### BEST MODE FOR CARRYING OUT THE INVENTION

Although terms such as "first," "second," "A," "B," "(a)," "(b)," and the like may be used herein to describe various members, components, regions, layers, or sections, these members, components, regions, layers, or sections are not to be limited by these terms. Rather, these terms are only used to distinguish one member, component, region, layer, or section from another member, component, region, layer, or section. Throughout the specification, when a component is described as being "connected to" or "coupled to" another component, it may be directly "connected to" or "coupled to" the other component, or there may be one or more other components intervening therebetween. In contrast, when an element is described as being "directly connected to" or "directly coupled to" another element, there can be no other elements intervening therebetween.

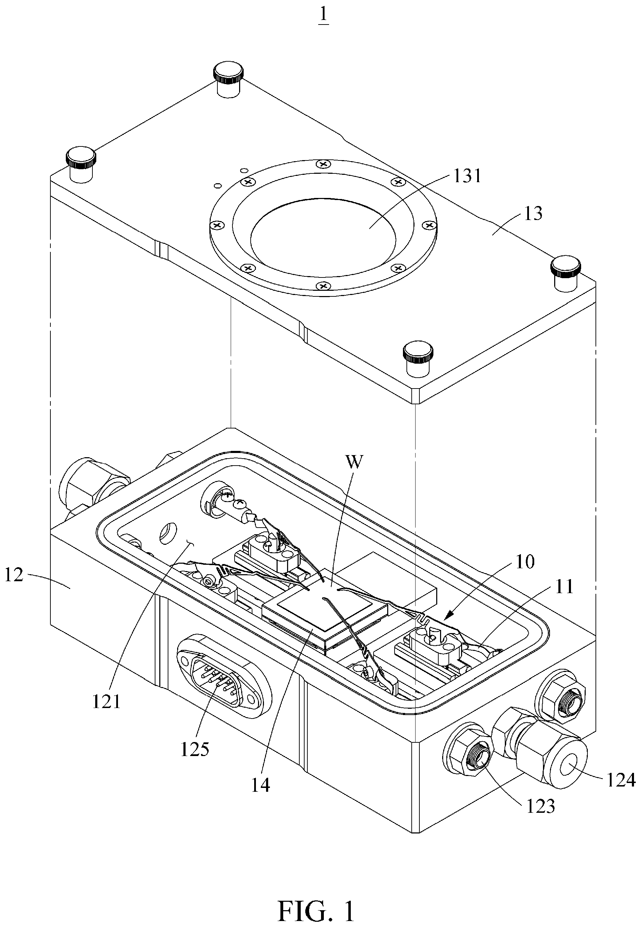

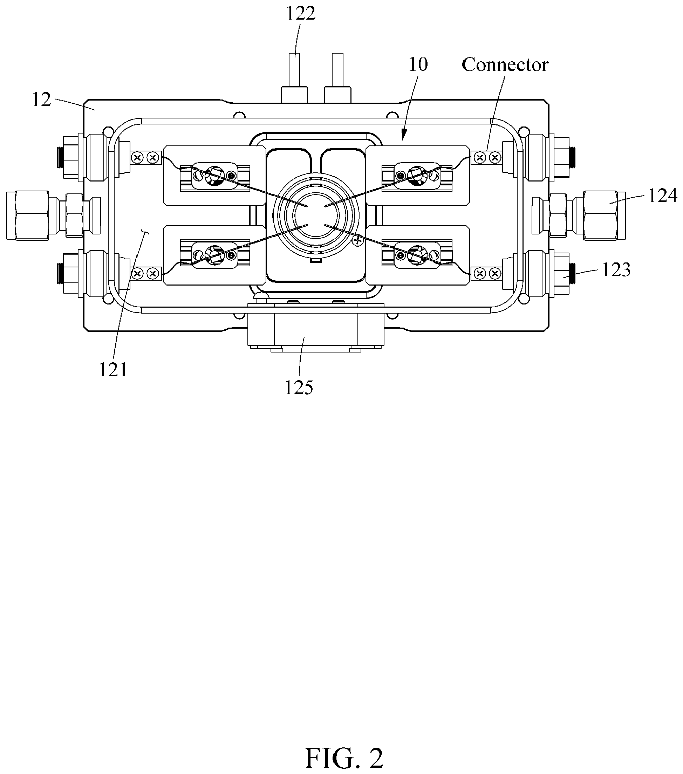

FIG 1 is a perspective view of a micro vacuum probe station according to an example embodiment. FIG 2 is a plan view of a micro vacuum probe station according to an example embodiment.

Referring to FIGS. 1 and 2, according to an example embodiment, a micro vacuum probe station 1 may detect material properties of a sample W. The sample W may be, for example, a semiconductor device formed on a substrate (e.g., a wafer). Although the sample W is illustrated in a quadrangular form in FIG 1, this is provided merely as an example and the sample W may be one of the various types of semiconductor devices formed on a wafer. The micro vacuum probe station 1 of the probe 106 may detect various properties, for example, electrical, optical, and chemical properties, of the sample W by interworking with another device. According to an example embodiment, the micro vacuum probe station 1 of the probe 106 includes a housing 12, a housing cover 13, a vacuum port 124, a cooling port 122, a signal port 123, a power connector 125, an sample stage 14, and a probe assembly 10.

The housing 12 may form an outer shape of the micro vacuum probe station 1 of the probe 106. The housing 12 may have a chamber 121 formed inside the housing 12, and an upper portion thereof may be opened. The chamber 121 may have a capacity less than or equal to 100 cubic centimeters (cc), for example. Using such a structure described in the foregoing, it is possible to form an inside of the chamber 121 to be in a vacuum state to examine the sample W, or rapidly purge gas in the inside of the chamber 121. Thus, even in a case in which the properties of the sample W are sensitive to an environment therearound, the micro vacuum probe station 1 of the probe 106 may accurately measure the properties of the sample W.

A sealing member that is disposed along a circumference of the chamber 121 may be provided on an upper surface of the housing 12. Thus, when the housing cover 13 and the housing 12 are connected to each other, the sealing member may seal a gap between the housing cover 13 and the housing 12, thereby allowing the chamber 121 to be hermetically sealed.

The housing cover 13 may be connected to the opened upper portion of the housing 12. The housing cover 13 may be selectively connected to the chamber 121 to close the chamber 121, thereby maintaining the vacuum state and the gas purging state inside the chamber 121. The housing cover 13 may have a fixing screw that is fixedly connected to the housing 12. For example, the fixing screw may be provided at an outer corner of the housing cover 13 and connected to a fixing groove (not shown) formed on an upper surface of the housing 12. The housing cover 13 may include a transparent window 131. The transparent window 131 may be formed with a transparent material that allows the inside of the chamber 121 to be observed from an outside. The transparent window 131 may be formed with a material, such as, for example, quartz, sapphire, glass, tempered glass, or acrylic. Using such a structure described in the foregoing, it is possible to detect an optical property of the sample W by radiating light through the transparent window 131 from the outside, and to detect an optical property generated from the sample W by inputting an electrical signal.

The vacuum port 124 may be formed through the outside of the housing 12 from the inside of the chamber 121. The vacuum port 124 may be connected to an exhaust line to perform a function as a path for emitting gas in the chamber 121. The vacuum port 124 may be connected to an other instrument to perform a function as a path for removing air in the chamber 121. The vacuum port 124 may also be connected to an other instrument to inject gas and moisture into the chamber 121. For example, when gas and moisture are injected into the chamber 121 in a process of detecting a chemical property of the sample W, the vacuum port 124 may perform a function as a path for injecting gas.

The cooling port 122 may be formed through the housing 12 such that a coolant flows into the chamber 121. The coolant for cooling the housing 12 may be injected through the cooling port 122. For example, the cooling port 122 may communicate with a cooling passage (not shown) formed to pass through an inside of the sample stage 14 to be described hereinafter, and thus perform a function as a path for injecting and discharging a coolant for cooling the sample stage 14. Using such a structure described in the foregoing, it is possible to adjust the temperature of the sample W disposed on the sample stage 14 by the flow of the coolant through the cooling port 122.

The signal port 123 may be formed through the housing 12 to connect a signal line for transmitting and receiving an electrical signal from the probe 106 to be described hereinafter. The signal port 123 may be connected to a connector that is connected to the probe 106, and connect an external signal line and the connector even in a vacuum or gas purging state maintained in the chamber 121.

The power connector 125 may perform a function as a connector for supplying power to the micro vacuum probe station 1 of the probe 106 and transmitting a direct current (DC) signal such as a signal of a temperature and humidity sensor.

The sample stage 14 may be provided in the chamber 121, and a target sample, for example, the sample W, for which an examination is to be performed may be settled on the sample stage 14. The sample stage 14 may be disposed at a center of the chamber 121. The sample stage 14 may include a temperature adjuster (not shown) to adjust the temperature of the sample W. The temperature adjuster may include, for example, a thermoelement formed as a peltier element, a resistive heater, and various heat exchangers. In such a case, the temperature adjuster may change the temperature of the sample stage 14 to adjust a target temperature of the sample W accurately and rapidly.

The cooling passage that communicates with the cooling port 122 may be provided in the sample stage 14. The coolant flowing in the chamber 121 through the cooling port 122 may reduce the temperature of the sample stage 14 while flowing along the cooling passage and then be discharged to the outside of the chamber 121.

Thus, the sample stage 14 may precisely adjust the temperature of the target sample W through the temperature adjuster and the cooling passage.

The probe assembly 10 may be disposed inside the chamber 121, and detect an electrical property of the sample W by contacting the sample W. The probe assembly 10 may be disposed around the sample stage 14. The probe assembly 10 may be provided as a plurality of probe assemblies, and the probe assemblies may simultaneously detect an electrical property of respective corresponding points of the sample W.

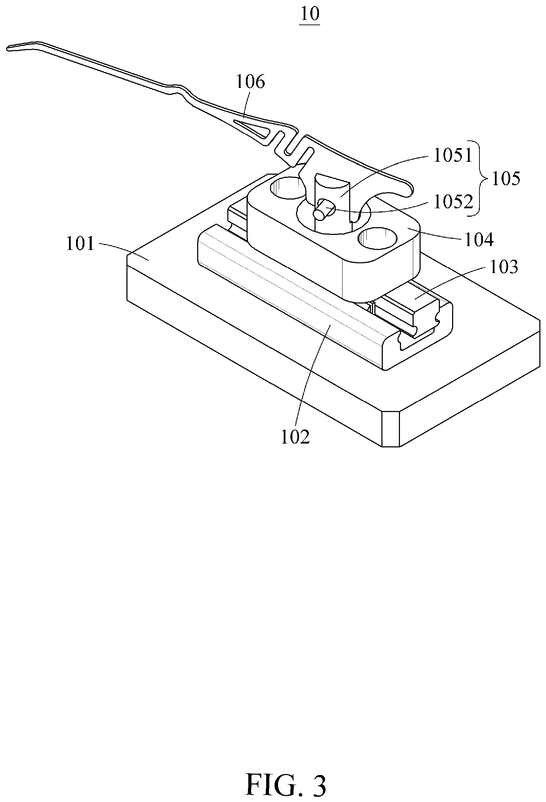

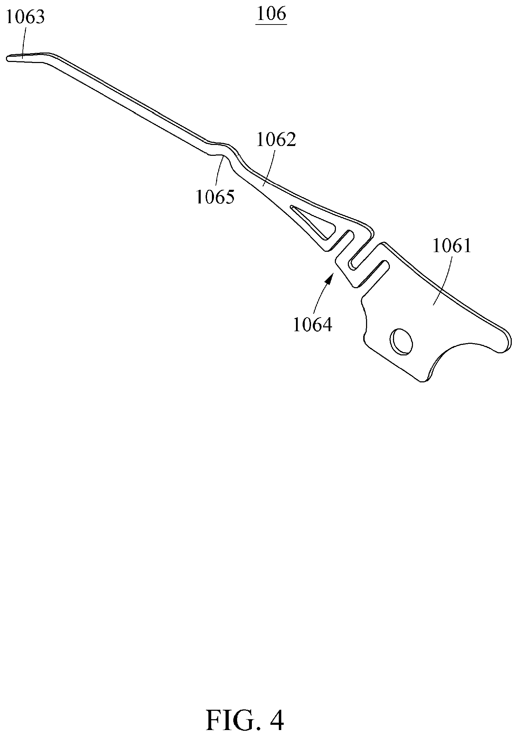

FIG 3 is a perspective view of a probe assembly according to an example embodiment. FIG 4 is a side perspective view of a probe according to an example embodiment.

Referring to FIGS. 3 and 4, the probe assembly 10 includes a base 101, a guide rail 102, a guide member 104, a connecting portion 105, the probe 106, and a thin film connector 11.

The base 101 may be installed on a bottom inside the chamber 121. A through groove that passes through in a vertical direction may be formed in the base 101. A screw may be inserted in the through groove to fix the base 101 to the bottom inside the chamber 121. The base 101 may be fixedly installed with a certain spacing separated from a surface of the bottom inside the chamber 121. In such a case, a plurality of elastic members (not shown) may be provided between the surface of the bottom of the chamber 121 and the base 101. The elastic members may have the same length and be disposed at both ends of the base 101. The elastic members may provide elasticity to allow the base 101 to be parallel to the surface of the bottom of the chamber 121. For example, when the probe 106 is brought into contact with the sample W, the base 101 may be inclined with respect to the surface of the bottom of the chamber 121 by an external force, allowing the probe 106 to be disposed on the sample W. In this example, the elastic members may provide elasticity to allow the base 101 to be parallel to the surface of the bottom of the chamber 121, thereby maintaining a state in which the probe 106 is in contact with the sample W. Thus, a certain force may act in a process of detecting an electrical property of the sample W, which may prevent the contact between the probe 106 and the sample W from being released. The spacing between the base 101 and the surface of the bottom may be adjusted through a screw, and elasticity provided by the elastic members may be adjusted by the spacing.

The guide rail 102 is provided on the base 101, and the guide member 104 may slide along the guide rail 102. The guide rail 102 may be a linear motion (LM) guide, for example. The guide member 104 may move in a direction approaching or receding the sample stage 14 while sliding along the guide rail 102. Thus, through the movement of the guide member 104, a distance of the probe 106 with respect to the sample W in a horizontal direction may be adjusted.

The connecting portion 105 may be provided in the guide member 104. The connecting portion 105 may connect the guide member 104 and the probe 106. The probe 106 may be connected to the connecting portion 105 such that it rotates on an axis perpendicular to the ground. According to an example embodiment, the connecting portion 105 includes a shaft 1051 and a connecting member 1052.

The shaft 1051 may be connected to an upper surface of the guide member 104 and include an insertion groove formed in an upper portion thereof. In the insertion groove, a portion of the probe 106, for example, a fixing portion 1061 of the probe 106 to be described hereinafter, may be inserted.

The connecting member 1052 may be connected to the shaft 1051 such that is passes through the probe 106 inserted in the insertion groove. As the probe 106 is inserted in a connecting hole that passes through a side surface of the shaft 1051, the connecting member 1052 may thus perform a function as a rotation axis of the probe 106 with respect to the shaft 1051.

The probe 106 may be connected to the guide member 104 through the connecting portion 105, and examine an electrical property of the sample W as one side of the probe 106 is brought into contact with the sample W. According to an example embodiment, the probe 106 includes the fixing portion 1061, an extension portion 1062, a bent portion 1064, an examination portion 1063, and an adjustment groove.

The fixing portion 1061 may be fixed to the connecting member 1052, and the connecting member 1052 may be connected to the guide member 104. The fixing portion 1061 includes an insertion hole that passes through a side surface to allow the connecting member 1052 to be inserted therein, and a contact portion formed on a rear end portion to be connected to the thin film connector 11. For a connection to the thin film connector 11, the connecting member 1052 between the fixing portion 1061 and the shaft 1051 may be used. Hereinafter, a direction of the probe 106 facing the sample W will be referred to as a front side or forward, and an opposite direction will be referred to as a rear side or backward, for the convenience of description.

The extension portion 1062 may extend in a horizontal direction from one side of the fixing portion 1061, for example, the front side of the fixing portion 1061. The extension portion 1062 may have a narrower width in a vertical direction compared to the fixing portion 1061, and be provided in the form of a thin pin.

The bent portion 1064 may connect the fixing portion 1061 and the extension portion 1062. As illustrated in FIG 4, the bent portion 1064 includes a cut pattern that is bent repeatedly in the vertical direction to allow the extension portion 1062 to be bent in a vertical direction with respect to the fixing portion 1061 and thus to be connected. The bent portion 1064 may also form an elastic structure. For example, when the extension portion 1062 receives an external force in a vertical direction, upper sides of bent points of the bent portion 1064 may become closer to each other, while lower sides of the bent points may become farther from each other. Thus, the extension portion 1062 may be flexibly bent with respect to the fixing portion 1061 to be connected thereto. In addition, the bent portion 1064 may have elasticity, as in a spring. Thus, when the external force is removed, the bent portion 1064 may provide elasticity such that a connection state of the connecting portion 105 with respect to the fixing portion 1061 returns to its original state. However, this is provided merely as an example, and the probe 106 may be provided in the form in which the fixing portion 1061 and the extension portion 1062 are connected without the bent portion 1064.

The examination portion 1063 may extend downward from a front end portion of the extension portion 1062. Thus, as the examination portion 1063 is brought into direct contact with the sample W, the examination portion 1063 may detect an electrical property of the sample W. To minimize a contact area with the sample W, the examination portion 1063 may be provided in the form of a pin having a cross section that is narrowed toward an end. To the examination portion 1063, a commercially used probe pin or wire including any one of tungsten, platinum, rhodium, stainless steel, and Inconel alloy may be attached.

An adjustment portion 1065 may be formed in the extension portion 1062 or the bent portion 1064, or the fixing portion 1061, to assist manual position adjustment for the probe 106. The adjustment portion 1065 may be formed as a portion of the extension portion 1062 is bent upward and a groove is thus formed on a lower side. A pair of tweezers or an adjustment jig for the manual position adjustment for the probe 106 may be inserted into the adjustment portion 1065. For example, to adjust a position of the probe 106 with respect to the sample W, a user may perform a manual type of a method of manually adjusting the position of the probe 106 through the tweezers. In this example, the adjustment portion 1065 may provide a space into which the tweezers are to be inserted, thereby facilitating the manual position adjustment for the probe 106. Also, using a separate external precision positioner and a jig that connects the positioner and the adjustment portion 1065, it is possible to assist position adjustment or manipulation more precisely than using the tweezers.

The thin film connector 11 is connected to the other side of the probe 106, for example, the contact portion of the probe 106, such that electricity is applied to the probe 106. The thin film connector 11 may be connected to the signal port 123 to apply electricity to the sample W through the probe 106 or transmit an electrical property of the sample W to the external signal line through the probe 106.

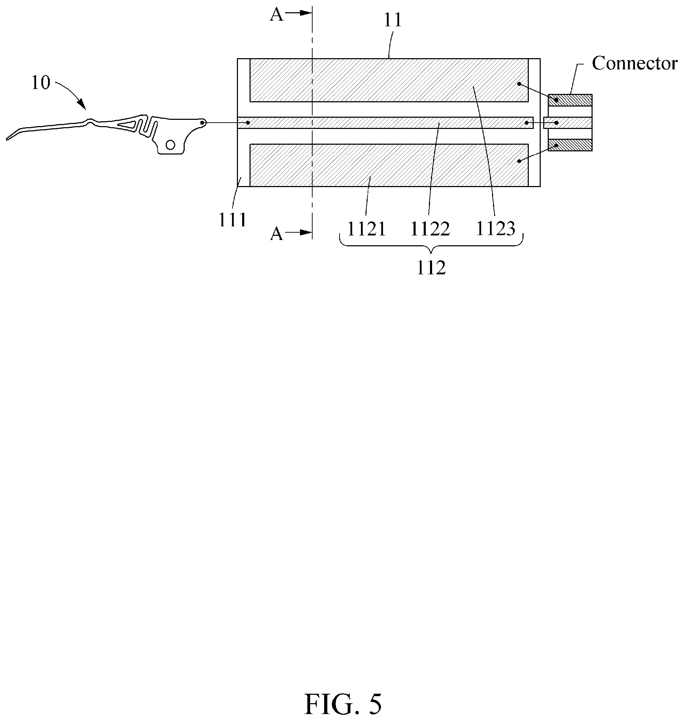

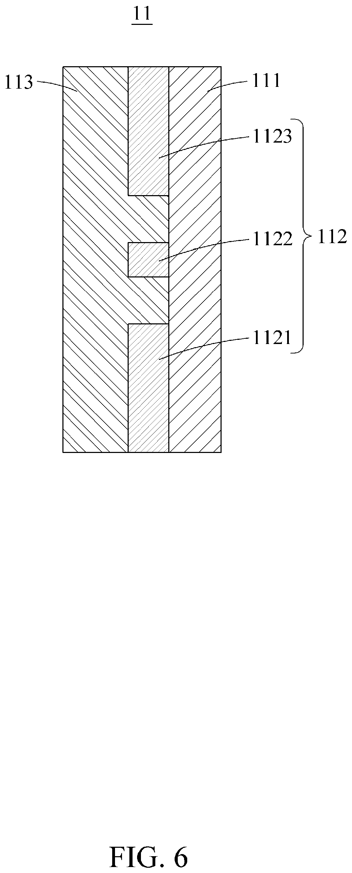

FIG 5 is a side view of a thin film connector according to the invention. FIG. 6 is a cross-sectional view of the thin film connector of FIG 5 cut by an A-A line.

Referring to FIGS. 5 and 6, the thin film connector 11 is provided in the form of a thin film. According to the invention, the thin film connector 11 includes a substrate layer 111, a conductive layer 112, and a cover layer 113.

The substrate layer 111 is formed with an insulating material comprising polyimide.

The conductive layer 112 is stacked on one surface of the substrate layer 111. The conductive layer 112 includes a material comprising copper. The conductive layer 112 is divided into a first conductive portion 1121, a second conductive portion 1123, and a third conductive portion 1122. The first conductive portion 1121 and the second conductive portion 1123 are stacked on one surface of the substrate layer 111 such that they are disposed at both ends of the substrate layer 111. The third conductive portion 1122 is stacked on one surface of the substrate layer 111 such that it is disposed at a center of the substrate layer 111, that is, a position between the first conductive portion 1121 and the second conductive portion 1123. In such a case, the first conductive portion 1121, the second conductive portion 1123, and the third conductive portion 1122 are stacked on the substrate layer 111 such that they are separated from one another.

The cover layer 113 is stacked on one surface of the substrate layer 111 to cover the conductive layer 112. The cover layer 113 may be stacked in the substrate layer 111 to fill in a space among the first conductive portion 1121, the second conductive portion 1123, and the third conductive portion 1122. The cover layer 113 may be formed with an insulating material to prevent electricity flowing in the conductive layer 112 from being leaked out to a portion that is not the thin film connector 11.

A position of the probe 106 may be adjusted forward and backward with respect to the sample W, and thus the thin film connector 11 may maintain the connection between the probe 106 and the thin film connector 11 while adjusting a gap between the probe 106 and the thin film connector 11 based on the adjusted position of the probe 106. In the case of the thin film connector 11 of such a described structure, it is provided in the form of a film and is bent or spread based on an adjusted position of the probe 106, and may thus maintain the connection while adjusting the gap between the probe 106 and the thin film connector 11.

In addition, using the thin film connector 11 of the described structure, it is possible to minimize noise that may occur when an alternating current (AC) voltage is applied to the probe 106, compared to using another type of electric wire. The AC voltage may have an inconsistent waveform, and thus great noise may occur when the probe 106 and a connector are connected through a general-type conductive line. Thus, in such a case, it may not be possible to accurately detect an electrical property of the sample W. However, using the thin film connector 11 of the described structure, noise that may occur when using the AC voltage may be reduced greatly and it may thus be possible to use a voltage, irrespective of whether it is a DC voltage or an AC voltage, to examine the sample W.

As described above, the micro vacuum probe station 1 of the probe 106 may linearly move the probe 106 in a direction parallel to the ground or rotate the probe 106 on an axis perpendicular to the ground, thereby facilitating the adjustment of a position of the probe 106 with respect to the sample W. In addition, using the thin film connector 11 that maintains an electrical connection between the probe 106 and the thin film connector 11 irrespective of a change in the position of the probe 106, it is possible to reduce the size of itself and thus minimize the size of the chamber 121. Thus, the micro vacuum probe station 1 of the probe 106 may minimize the size of the chamber 121 and reduce the amount of time used to change the chamber 121 into a vacuum state or to purge gas, thereby accurately and rapidly detecting a change in properties of the sample W by a change in environment.

In addition, by adjusting the temperature of the observation station 14, it is possible to rapidly adjust the temperature to be applied to the sample W and accurately detect properties of the sample W based on the change in the temperature.

Further, as the size of a device is reduced, it is thus possible to increase the compatibility with an other instrument for optical measurement and the like.

## Claims

1. A probe assembly (10), comprising:
a base (101);
a guide rail (102) installed on the base (101);
a guide member (104) configured to slide along the guide rail (102);
a probe (106) connected to the guide member (104) and configured to examine an electrical property of a sample (W) as one side thereof is brought into contact with the sample (W); and
a thin film connector (11) connected to the other side of the probe (106) such that electricity is applied to the probe (106);
**characterized in that** the thin film connector (11) comprises:
a substrate layer (111) comprising polyimide;
a conductive layer (112) comprising copper and stacked on one surface of the substrate layer (111); and
a cover layer (113) stacked on one surface of the substrate layer (111) to cover the conductive layer (112);
wherein the conductive layer (112) comprises:
a first conductive portion (1121) and a second conductive portion (1123) stacked on the substrate layer (111) such that the first conductive portion (1121) and the second conductive portion (1123) are disposed at both ends of the substrate layer (111), and a third conductive portion (1122) stacked on the substrate layer (111) such that the third conductive portion (1122) is disposed between the first conductive portion (1121) and the second conductive portion (1123),
wherein the first conductive portion (1121), the second conductive portion (1123), and the third conductive portion (1122) are separated from one another,
wherein a cross section of the first conductive portion (1121) and a cross section of the second conductive portion (1123) are larger than a cross section of the third conductive portion (1122),
wherein the probe (106) is electrically connected to the third conductive portion (1122).

2. The probe assembly (10) of claim 1, further comprising:
a connecting portion (105) configured to connect the guide member (104) and the probe (106),
wherein the probe (106) is connected to the connecting portion (105) such that the probe (106) is rotatable on an axis perpendicular to the ground.

3. The probe assembly (10) of claim 2, wherein the connecting portion (105) comprises:
a connecting member (1052) connected to the guide member (104) and having, in an upper portion thereof, an insertion groove into which a portion of the probe (106) is to be inserted;
a shaft (1051) provided in the connecting member (1052) to pass through the probe (106); and
an elastic body connected to the shaft (1051) and configured to provide a restoring force such that the probe (106) rotates in an opposite direction when the probe (106) rotates through the shaft (1051).

4. The probe assembly (10) of claim 1, wherein the probe (106) comprises:
a fixing portion (1061) connected to the guide member (104);
an extension portion (1062) extending in a horizontal direction from one side of the fixing portion (1061); and
an examination portion (1063) extending downward from an end portion of the extension portion (1062) such that an end portion thereof comes into contact with the sample (W).

5. The probe assembly (10) of claim 4, wherein the probe (106) further comprises:
a bent portion (1064) configured to connect the fixing portion (1061) and the extension portion (1062), and repeatedly bent such that the extension portion (1062) bends upward and downward with respect to the fixing portion (1061).

6. The probe assembly (10) of claim 4, wherein the extension portion (1062) comprises:
an adjustment groove formed by being bent upward,
wherein, into the adjustment groove, tweezers for manually adjusting a position of the probe are inserted.

7. A micro vacuum probe station (1), comprising:
a housing (12) having a chamber (121) formed inside the housing (12) and having an upper portion being opened;
a housing cover (13) connected to the upper portion of the housing (12) to hermetically seal the chamber (121) and comprising a transparent window (131);
a vacuum port (124) formed through the housing (12) to form a vacuum in the chamber (121);
an sample stage (14) disposed in the chamber (121) and on which a target sample is to be settled; and
a probe assembly (10) according to any one of the preceding claims,
wherein the probe assembly (10) disposed in the chamber (121) and configured to examine an electrical property of the sample (W) as the probe assembly (10) is brought into contact with the sample (W).

8. The micro vacuum probe station (1) of claim 7,
wherein the base (101) is installed in the chamber (121);
wherein the guide rail (102) is provided in the base (101).

9. The micro vacuum probe station (1) of claim 8, wherein the thin film connector (11) comprises:
a substrate layer (111) formed with an insulating material;
a conductive layer (112) stacked on one surface of the substrate layer (111), and comprising three conductive portions disposed at both ends and a center of the substrate layer (111) such that the conductive portions are separated from one another; and
a cover layer (113) stacked on one surface of the substrate layer (111) to cover the conductive layer (112).

10. The micro vacuum probe station (1) of claim 9, wherein, to the probe (106), an alternating current (AC) voltage is applied through the thin film connector (11).

11. The micro vacuum probe station (1) of claim 7, wherein the probe (106) assembly further comprises:
an elastic member disposed between a surface of a bottom of the chamber (121) and the base (101).

12. The micro vacuum probe station (1) of claim 7, further comprising:
a cooling port (122) formed through the housing (12) such that a coolant flows into the chamber (121).

13. The micro vacuum probe station (1) of claim 7, wherein the sample stage (14) comprises:
a temperature adjuster configured to adjust a temperature of the sample (W).

## Patentansprüche

1. Sondenanordnung (10), umfassend:
eine Basis (101);
eine Führungsschiene (102), die an der Basis (101) installiert ist;
ein Führungselement (104), das konfiguriert ist, um entlang der Führungsschiene (102) zu gleiten;
eine Sonde (106), die mit dem Führungselement (104) verbunden und konfiguriert ist, um eine elektrische Eigenschaft einer Probe (W) zu untersuchen, während eine Seite davon in Kontakt mit der Probe (W) gebracht wird; und
einen Dünnfilmverbinder (11), der mit der anderen Seite der Sonde (106) derart verbunden ist, dass Elektrizität an die Sonde (106) angelegt wird;
**dadurch gekennzeichnet, dass** der Dünnfilmverbinder (11) umfasst:
eine Substratschicht (111), umfassend Polyimid;
eine leitfähige Schicht (112), umfassend Kupfer und die auf einer Oberfläche der Substratschicht (111) gestapelt ist; und
eine Deckschicht (113), die auf einer Oberfläche der Substratschicht (111) gestapelt ist, um die leitfähige Schicht (112) abzudecken;
wobei die leitfähige Schicht (112) umfasst:
einen ersten leitfähigen Abschnitt (1121) und einen zweiten leitfähigen Abschnitt (1123), die auf der Substratschicht (111) derart gestapelt sind, dass der erste leitfähige Abschnitt (1121) und der zweite leitfähige Abschnitt (1123) an beiden Enden der Substratschicht (111) eingerichtet sind, und einen dritten leitfähigen Abschnitt (1122), der auf der Substratschicht (111) derart gestapelt ist, dass der dritte leitfähige Abschnitt (1122) zwischen dem ersten leitfähigen Abschnitt (1121) und dem zweiten leitfähigen Abschnitt (1123) eingerichtet ist,
wobei der erste leitfähige Abschnitt (1121), der zweite leitfähige Abschnitt (1123) und der dritte leitfähige Abschnitt (1122) voneinander getrennt sind,
wobei ein Querschnitt des ersten leitfähigen Abschnitts (1121) und ein Querschnitt des zweiten leitfähigen Abschnitts (1123) größer als ein Querschnitt des dritten leitfähigen Abschnitts (1122) sind,
wobei die Sonde (106) mit dem dritten leitfähigen Abschnitt (1122) elektrisch verbunden ist.

2. Sondenanordnung (10) nach Anspruch 1, ferner umfassend:
einen Verbindungsabschnitt (105), der konfiguriert ist, um das Führungselement (104) und die Sonde (106) zu verbinden,
wobei die Sonde (106) mit dem Verbindungsabschnitt (105) derart verbunden ist, dass die Sonde (106) auf einer Achse senkrecht zu dem Boden drehbar ist.

3. Sondenanordnung (10) nach Anspruch 2, wobei der Verbindungsabschnitt (105) umfasst:
ein Verbindungselement (1052), das mit dem Führungselement (104) verbunden ist und, in einem oberen Abschnitt davon, eine Einführnut aufweist, in die ein Abschnitt der Sonde (106) einzuführen ist;
einen Schaft (1051), der in dem Verbindungselement (1052) bereitgestellt ist, um die Sonde (106) zu durchlaufen; und
einen elastischen Körper, der mit dem Schaft (1051) verbunden und konfiguriert ist, um eine Rückstellkraft derart bereitzustellen, dass sich die Sonde (106) in eine entgegengesetzte Richtung dreht, wenn sich die Sonde (106) durch den Schaft (1051) dreht.

4. Sondenanordnung (10) nach Anspruch 1, wobei die Sonde (106) umfasst:
einen Befestigungsabschnitt (1061), der mit dem Führungselement (104) verbunden ist;
einen Erstreckungsabschnitt (1062), der sich in einer horizontalen Richtung von einer Seite des Befestigungsabschnitts (1061) erstreckt; und
einen Untersuchungsabschnitt (1063), der sich von einem Endabschnitt des Erstreckungsabschnitts (1062) derart nach unten erstreckt, dass ein Endabschnitt davon mit der Probe (W) in Kontakt kommt.

5. Sondenanordnung (10) nach Anspruch 4, wobei die Sonde (106) ferner umfasst:
einen gebogenen Abschnitt (1064), der konfiguriert ist, um den Befestigungsabschnitt (1061) und den Erstreckungsabschnitt (1062) zu verbinden, und derart wiederholt gebogen ist, dass sich der Erstreckungsabschnitt (1062) in Bezug auf den Befestigungsabschnitt (1061) nach oben und nach unten biegt.

6. Sondenanordnung (10) nach Anspruch 4, wobei der Erstreckungsabschnitt (1062) umfasst:
eine über Aufwärtsbiegen ausgebildete Einstellnut,
wobei, in die Einstellnut, eine Pinzette zum manuellen Einstellen einer Position der Sonde eingeführt wird.

7. Mikrovakuumsondenstation (1), umfassend:
ein Gehäuse (12), das eine Kammer (121) aufweist, die im Inneren des Gehäuses (12) ausgebildet ist, und das einen oberen Abschnitt, der geöffnet ist, aufweist;
eine Gehäuseabdeckung (13), die mit dem oberen Abschnitt des Gehäuses (12) verbunden ist, um die Kammer (121) hermetisch abzudichten, und umfassend ein transparentes Fenster (131);
eine Vakuumöffnung (124), die durch das Gehäuse (12) ausgebildet ist, um ein Vakuum in der Kammer (121) auszubilden;
einen Probentisch (14), der in der Kammer (121) eingerichtet ist und auf dem eine Zielprobe abzulegen ist; und
eine Sondenanordnung (10) nach einem der vorstehenden Ansprüche,
wobei die Sondenanordnung (10) in der Kammer (121) eingerichtet und konfiguriert ist, um eine elektrische Eigenschaft der Probe (W) zu untersuchen, während die Sondenanordnung (10) mit der Probe (W) in Kontakt gebracht wird.

8. Mikrovakuumsondenstation (1) nach Anspruch 7,
wobei die Basis (101) in der Kammer (121) installiert ist;
wobei die Führungsschiene (102) in der Basis (101) bereitgestellt ist.

9. Mikrovakuumsondenstation (1) nach Anspruch 8, wobei der Dünnfilmverbinder (11) umfasst:
eine Substratschicht (111), die mit einem isolierenden Material ausgebildet ist;
eine leitfähige Schicht (112), die auf einer Oberfläche der Substratschicht (111) gestapelt ist und umfassend drei leitfähige Abschnitte, die an beiden Enden und einer Mitte der Substratschicht (111) derart eingerichtet sind, dass die leitfähigen Abschnitte voneinander getrennt sind; und
eine Deckschicht (113), die auf einer Oberfläche der Substratschicht (111) gestapelt ist, um die leitfähige Schicht (112) abzudecken.

10. Mikrovakuumsondenstation (1) nach Anspruch 9, wobei, an die Sonde (106), eine Wechselstromspannung (AC-Spannung) durch den Dünnfilmverbinder (11) angelegt wird.

11. Mikrovakuumsondenstation (1) nach Anspruch 7, wobei die Sondenanordnung (106) ferner umfasst:
ein elastisches Element, das zwischen einer Oberfläche eines Bodens der Kammer (121) und der Basis (101) eingerichtet ist.

12. Mikrovakuumsondenstation (1) nach Anspruch 7, ferner umfassend:
eine Kühlöffnung (122), die durch das Gehäuse (12) derart ausgebildet ist, dass ein Kühlmittel in die Kammer (121) strömt.

13. Mikrovakuumsondenstation (1) nach Anspruch 7, wobei der Probentisch (14) umfasst:
eine Temperatureinstellungsvorrichtung, die konfiguriert ist, um eine Temperatur der Probe (W) einzustellen.

## Revendications

1. Ensemble sonde (10), comprenant :
une base (101) ;
un rail de guidage (102) installé sur la base (101) ;
un élément de guidage (104) conçu pour coulisser le long du rail de guidage (102) ;
une sonde (106) reliée à l'élément de guidage (104) et configurée pour examiner une propriété électrique d'un échantillon (W) lorsqu'un côté de celle-ci est amené en contact avec l'échantillon (W) ; et
un connecteur à couche mince (11) connecté à l'autre côté de la sonde (106) de telle sorte que de l'électricité soit appliquée à la sonde (106) ;
**caractérisé en ce que** le connecteur à couche mince (11) comprend :
une couche de substrat (111) comprenant du polyimide ;
une couche conductrice (112) comprenant du cuivre et empilée sur une surface de la couche de substrat (111) ; et
une couche de couverture (113) empilée sur une surface de la couche de substrat (111) pour recouvrir la couche conductrice (112) ;
dans lequel la couche conductrice (112) comprend :
une première portion conductrice (1121) et une deuxième portion conductrice (1123) empilées sur la couche de substrat (111) de telle sorte que la première portion conductrice (1121) et la deuxième portion conductrice (1123) sont disposées au niveau des deux extrémités de la couche de substrat (111), et une troisième portion conductrice (1122) empilée sur la couche de substrat (111) de telle sorte que la troisième portion conductrice (1122) est disposée entre la première portion conductrice (1121) et la deuxième portion conductrice (1123),
dans lequel la première portion conductrice (1121), la deuxième portion conductrice (1123) et la troisième portion conductrice (1122) sont séparées les unes des autres,
dans lequel une section transversale de la première portion conductrice (1121) et une section transversale de la deuxième portion conductrice (1123) sont plus grandes qu'une section transversale de la troisième portion conductrice (1122),
dans lequel la sonde (106) est connectée électriquement à la troisième portion conductrice (1122).

2. Ensemble sonde (10) selon la revendication 1, comprenant en outre :
une portion de liaison (105) conçue pour relier l'élément de guidage (104) et la sonde (106),
dans lequel la sonde (106) est reliée à la portion de liaison (105) de telle sorte que la sonde (106) est rotative autour d'un axe perpendiculaire au sol.

3. Ensemble sonde (10) selon la revendication 2, dans lequel la portion de liaison (105) comprend :
un élément de liaison (1052) relié à l'élément de guidage (104) et présentant, dans une portion supérieure de celui-ci, une rainure d'insertion dans laquelle une portion de la sonde (106) doit être insérée ;
un arbre (1051) prévu dans l'élément de liaison (1052) pour traverser la sonde (106) ; et
un corps élastique relié à l'arbre (1051) et conçu pour fournir une force de rappel de telle sorte que la sonde (106) tourne dans un sens opposé lorsque la sonde (106) tourne par l'intermédiaire de l'arbre (1051).

4. Ensemble sonde (10) selon la revendication 1, dans lequel la sonde (106) comprend :
une portion de fixation (1061) reliée à l'élément de guidage (104) ;
une portion d'extension (1062) s'étendant dans une direction horizontale à partir d'un côté de la portion de fixation (1061) ; et
une portion d'examen (1063) s'étendant vers le bas à partir d'une portion extrémité de la portion d'extension (1062) de telle sorte qu'une portion extrémité de celle-ci vient en contact avec l'échantillon (W).

5. Ensemble sonde (10) selon la revendication 4, dans lequel la sonde (106) comprend en outre :
une portion pliée (1064) conçue pour relier la portion de fixation (1061) et la portion d'extension (1062), et pliée de manière répétée de telle sorte que la portion d'extension (1062) se plie vers le haut et vers le bas par rapport à la portion de fixation (1061).

6. Ensemble sonde (10) selon la revendication 4, dans lequel la portion d'extension (1062) comprend :
une rainure de réglage formée en étant pliée vers le haut,
dans lequel, dans la rainure de réglage, des pincettes pour régler manuellement une position de la sonde sont insérées.

7. Station de sonde à micro-vide (1), comprenant :
un boîtier (12) présentant une chambre (121) formée à l'intérieur du boîtier (12) et présentant une portion supérieure ouverte ;
un couvercle de boîtier (13) relié à la portion supérieure du boîtier (12) pour sceller hermétiquement la chambre (121) et comprenant une fenêtre transparente (131) ;
un orifice de vide (124) formé à travers le boîtier (12) pour former un vide dans la chambre (121) ;
un porte-échantillon (14) disposé dans la chambre (121) et sur lequel un échantillon cible doit être déposé ; et
un ensemble sonde (10) selon l'une quelconque des revendications précédentes,
dans laquelle l'ensemble sonde (10) est disposé dans la chambre (121) et configuré pour examiner une propriété électrique de l'échantillon (W) lorsque l'ensemble sonde (10) est amené en contact avec l'échantillon (W).

8. Station de sonde à micro-vide (1) selon la revendication 7,
dans laquelle la base (101) est installée dans la chambre (121) ;
dans laquelle le rail de guidage (102) est prévu dans la base (101).

9. Station de sonde à micro-vide (1) selon la revendication 8, dans laquelle le connecteur à couche mince (11) comprend :
une couche de substrat (111) formée d'un matériau isolant ;
une couche conductrice (112) empilée sur une surface de la couche de substrat (111), et comprenant trois portions conductrices disposées au niveau de deux extrémités et à un centre de la couche de substrat (111) de telle sorte que les portions conductrices sont séparées les unes des autres ; et
une couche de couverture (113) empilée sur une surface de la couche de substrat (111) pour recouvrir la couche conductrice (112).

10. Station de sonde à micro-vide (1) selon la revendication 9, dans laquelle, à la sonde (106), une tension de courant alternatif (CA) est appliquée par l'intermédiaire du connecteur à couche mince (11).

11. Station de sonde à micro-vide (1) selon la revendication 7, dans laquelle l'ensemble sonde (106) comprend en outre :
un élément élastique disposé entre une surface d'un fond de la chambre (121) et la base (101).

12. Station de sonde à micro-vide (1) selon la revendication 7, comprenant en outre :
un orifice de refroidissement (122) formé à travers le boîtier (12) de telle sorte qu'un fluide de refroidissement s'écoule dans la chambre (121).

13. Station de sonde à micro-vide (1) selon la revendication 7, dans laquelle le porte-échantillon (14) comprend :
un dispositif de réglage de température configuré pour ajuster une température de l'échantillon (W).
